# EUROPEAN PATENT APPLICATION

(11) **EP 4 746 616 A2**
(43) Date of publication of application: **20.05.2026**
(21) Application number: 25213631.2
(22) Date of filing: 05.11.2025
(51) Int. Cl.: H10B 12/00, H10B 41/40, H10B 43/40

(54) **CONTACT STRUCTURE HAVING VERTICAL ISOLATION BETWEEN PADS**

(30) Priority: 13.11.2024 US 202463720169 P; 18.07.2025 US 202519274207
(71) Applicant: Samsung Electronics Co., Ltd., Suwon-si, Gyeonggi-do 16677 (KR)
(72) Inventor: KIM, Dongwan, San Jose, CA, 95134 (US); DUTTA, Moumita, San Jose, CA, 95134 (US); AHN, Jaesoo, San Jose, CA, 95134 (US)
(74) Representative: Kuhnen & Wacker Patent- und Rechtsanwaltsbüro PartG mbB

(57) **Abstract**

A system and a method for a contact structure are disclosed. The contact structure includes at least a first contact pillar and a second contact pillar. The first contact pillar is connected to a first contact point on a first metal layer in a first semiconductor region at a first depth. The second contact pillar is connected to a second contact point on a second metal layer in the first semiconductor region at a second depth longer than the first depth with respect to a top surface of a second semiconductor region on top of the first semiconductor region. The first and second contact points are isolated in a direction along the first and second depths. The first and second metal layers correspond to first and second wordlines, WLs, respectively, of a memory circuit.

## Description

### TECHNICAL FIELD

The disclosure generally relates to memory devices. More particularly, the subject matter disclosed herein relates to contact structure for wordlines in memory circuits.

### BACKGROUND

The present background section is intended to provide context only, and the disclosure of any concept in this section does not constitute an admission that said concept is prior art.

Three-dimensional (3-D) memory configurations have been increasingly popular. 3-D memory devices, such as vertically stacked dynamic random-access memory (VSDRAM) and vertical NAND (V-NAND) flash memory, include memory cells that are stacked vertically to increase storage density. One feature of 3-D memory circuits is the arrangement of control lines in a staircase structure. The staircase is employed to form the electrical connection between the control gate and contact. However, when the number of layers increases, the usable area for the memory channel decreases. In addition, structural support for a large number of layers may present problems. Accordingly, staircase-free designs aim at removing the staircase configuration while maintaining the same level of desired density. One particular feature of staircase-free memory circuits is contact structures for wordlines.

Existing techniques for designing contact pads for wordlines have several problems. One problem is the use of lateral isolation between pads. This type of isolation occupies space on the side of the memory cells to accommodate the isolation. Accordingly, the side of logic circuits has a limited space.

The above information disclosed in this Background section is only for enhancement of understanding of the background of the disclosure and therefore it may contain information that does not constitute prior art.

### SUMMARY

To overcome these issues, systems and methods are described herein for a technique of providing a contact structure for WLs in a three-dimensional (3-D) memory device. In some embodiments, the contact structure includes at least a first contact pillar and a second contact pillar. The first contact pillar is connected to a first contact point on a first metal layer in a first semiconductor region at a first depth. The second contact pillar is connected to a second contact point on a second metal layer in the first semiconductor region at a second depth deeper than the first depth with respect to a top surface of a second semiconductor region on top of the first semiconductor region. The first and second contact points are isolated in a direction along the first and second depths. The first and second metal layers correspond to first and second wordlines (WLs), respectively, of a memory circuit.

In some embodiments, the first and second contact pillars are through-substrate or silicon deep vias (TSDVs). The first and second contact pillars form a vertical multi-level bonding structure around the first and second contact points and the first and second metal layers and are filled with a conducting material. In one embodiment, the conducting material may be one of titanium nitride (TiN) or tungsten (W). The second contact pillar punches through the first metal layer at a first punch-through location.

### BRIEF DESCRIPTION OF THE DRAWINGS

In the following section, the aspects of the subject matter disclosed herein will be described with reference to exemplary embodiments illustrated in the figures, in which:
FIG. 1 is a block diagram illustrating a system that utilizes a 3-D memory circuit according to an embodiment.
FIG. 2 is a diagram illustrating a contact structure in a 3-D memory circuit according to an embodiment.
FIG. 3 is a diagram illustrating a comparison between a contact structure with vertical isolation and a contact structure with lateral isolation according to an embodiment.
FIG. 4 is a diagram illustrating a first stage of the manufacturing process of the contact structure according to an embodiment.
FIG. 5 is a diagram illustrating a second stage of the manufacturing process of the contact structure according to an embodiment.
FIG. 6 is a diagram illustrating a third stage of the manufacturing process of the contact structure according to an embodiment.
FIG. 7 is a diagram illustrating a fourth stage of the manufacturing process of the contact structure according to an embodiment.
FIG. 8 is a diagram illustrating a fifth stage of the manufacturing process of the contact structure according to an embodiment.
FIG. 9 is a diagram illustrating a sixth stage of the manufacturing process of the contact structure according to an embodiment.
FIG. 10 is a diagram illustrating a lateral isolation at a punch-through location of the contact structure according to an embodiment.
FIG. 11 is a diagram illustrating a three-pillar structure of the contact structure according to an embodiment.
FIG. 12 is a flowchart illustrating a process of manufacturing a contact structure according to an embodiment.
FIG. 13 is a flow chart illustrating a process of bonding two semiconductor regions in the manufacturing process of the contact structure according to an embodiment.
FIG. 14 is a flow chart illustrating a process of etching holes to form first and second TSDVs in the manufacturing process of the contact structure according to an embodiment.
FIG. 15 is a flow chart illustrating a process of cleaning the second TSDV in the manufacturing process of the contact structure according to an embodiment.
FIG. 16 is a flow chart illustrating a process of inserting liners into the TSDVs in the manufacturing process of the contact structure for a memory circuit according to an embodiment.
FIG. 17 is a flow chart illustrating a process of etching holes to cause the second TSDV to land on, or contact, the second metal layer in the manufacturing process of the contact structure according to an embodiment.
FIG. 18 is a flow chart illustrating a process of patterning in the manufacturing process of the contact structure according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Many applications, especially applications in Artificial Intelligence (AI) and signal processing, require a vast storage capacity and high throughput computations. To satisfy these needs, highly dense memory circuits in 3-D configurations are developed. In the following, systems and methods are described as a technique of providing a contact structure for WLs in a 3-D memory device. In some embodiments, the contact structure includes at least a first contact pillar and a second contact pillar. There are at least two metal layers that are arranged in parallel in a horizontal direction. The horizontal direction is the direction of the ground surface or a flat surface parallel with the ground surface. The vertical direction is the direction substantially perpendicular to the horizontal direction. A point on any of the metal layer may serve as a contact point for connection to other contact points or conducive lines. The first contact pillar is connected to a first contact point on a first metal layer in a first semiconductor region at a first depth. The second contact pillar is connected to a second contact point on a second metal layer in the first semiconductor region at a second depth deeper or longer than the first depth with respect to a top surface of a second semiconductor region on top of the first semiconductor region. The first and second contact points are isolated in a direction along the first and second depths. The distance between the two metal layers determines the amount of isolation and mechanical integrity of the two contact pillars. The first and second metal layers correspond to first and second wordlines (WLs), respectively, of a memory circuit. Contact pads may be made at the contact points.

In some embodiments, the first and second contact pillars are through-substrate or silicon deep vias (TSDVs) or through silicon vias (TSVs). The first and second contact pillars form a vertical multi-level bonding structure around the first and second contact points and the first and second metal layers and are filled with a conducting material. In one embodiment, the conducting material may be one of titanium nitride (TiN) or tungsten (W). The second contact pillar punches through the first metal layer at a first punch-through location.

The contact structure described herein has several technical advantages. Thanks to the vertical isolation, the distance between the two contact pillars is narrower than when they are arranged for lateral or horizontal isolation. The result is that the lateral or horizontal space between the two pillars is shorter. This leaves space in the semiconductor part (e.g., wafer, die) for silicon areas that may be used for logic circuits or other functionalities.

In the following, figures depicting various components, structures, interconnections, configurations, and steps of fabrication, are mainly for illustrative purposes. They are not intended to describe these elements accurately. In some cases, relevant parts in a figure are shown clearly while other parts are shown with less sharpness or clarity to avoid confusion and improve clarity. These parts may be referenced in earlier figures and therefore do not need to be described again. These parts may also have little relationship with the part(s) being described. In addition, the shading of the parts in the figures may not have a consistent design and may be changed to maintain clarity and contrast in the figures. For example, part A may have a light shading in Fig. X but may be heavily shaded in Fig. Y. Moreover, as mentioned above, components in a figure may not be drawn with proper scales.

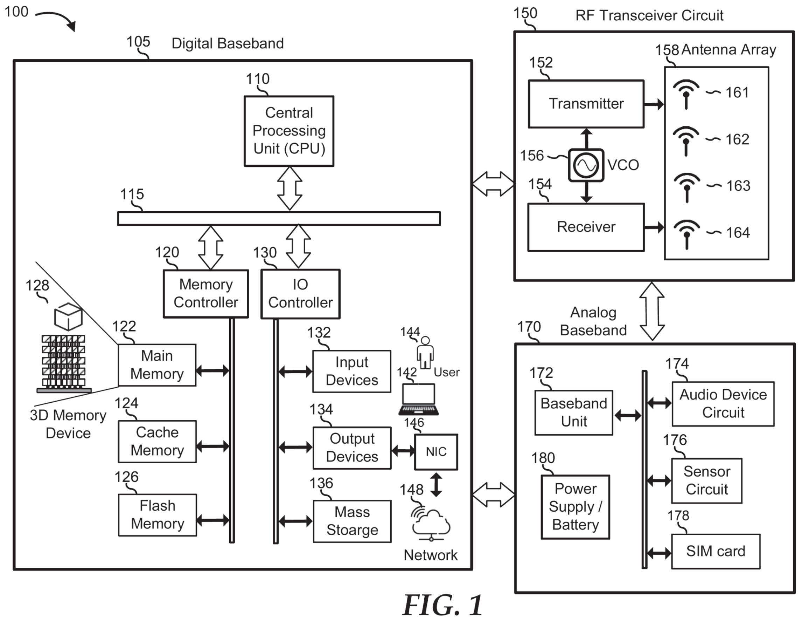

FIG. 1 is a block diagram illustrating a system that utilizes a 3-D memory circuit according to an embodiment. The system 100 includes a digital baseband circuit 105, a radio frequency (RF) transceiver circuit 150, and an analog baseband circuit 170. The system 100 may represent a digital system or a mobile system. When the system 100 is used as a digital system without mobile circuitry, the RF transceiver circuit 150, and the analog baseband circuit 170 are not used. In addition, when the system 100 is used as a mobile device, many of the digital devices are scaled back and some devices may not be available.

The digital baseband circuit 105 includes central processing unit (CPU) 110, a memory controller 120, and an I/O controller 130. The system 100 may include more or less than the above components. In addition, a component may be integrated into another component. The integration may be partial and/or overlapped. For example, the memory controller 120 and the I/O controller 130 may be integrated into one single controller.

The CPU 110 is a programmable device that may execute a program or a collection of instructions to carry out a task. It may be a host that controls or manages other processors or devices. In particular, the CPU 110 may include applications programming interfaces (APIs), applications, or drivers that are executed by the CPU 110 to perform specified tasks. The CPU 110 may be a general-purpose processor, a digital signal processor, a microcontroller, or a specially designed processor. It may include a single core or multiple cores. Each core may have multi-way multi-threading. The CPU 110 may have simultaneous multithreading feature to further exploit the parallelism due to multiple threads across the multiple cores. In addition, the CPU 110 may have internal caches at multiple levels. The CPU 110 communicates with other devices in the system via a bus 115. The bus 115 may be any suitable bus connecting the CPU 110 to other devices. For example, the bus 115 may be a Direct Media Interface (DMI). The bus 115 may also include other custom buses such as bus for the interface to the analog section when the system 100 is used as a mobile device.

The memory controller 120 controls memory devices such as a main memory 122, a cache memory 124, and a flash memory 126. The main memory 122 includes random access memory (RAM) including static RAM (SRAM) and dynamic RAM (DRAM) and/or the read-only memory (ROM) and other types of memory. The DRAM may include Synchronous DRAM (SDRAM), Double Data Rate SDRAM (DDR SDRAM) with variations (e.g., DDR2, DDR3, DDR4, DDR5, and DDR6). The main memory 122 may store instructions or programs, loaded from a mass storage device, that, when executed by the CPU 110, cause the CPU 110 to perform operations for a specified task. It may also store data used in the operations. The ROM may be a solid-state drive (SSD) and include instructions, programs, constants, or data that are maintained whether it is powered or not. In one embodiment, the main memory 122 includes a 3-D memory device or circuit 128 such as VSDRAM and V-NAND flash memory, or any other memory devices that have memory cells that are stacked vertically to increase storage density

The I/O controller 130 controls input devices 132, output devices 134, and mass storage 136. The input devices 132 may include a keyboard, a mouse, an image sensor or camera, a game console, and a microphone. Other input devices may also be available such as stylus, joystick, scanner, and light pen. The input devices may also have a user interface to interface to a computer or laptop 142 and/or a user 144. The output devices 134 may include a printer, a monitor or screen, a headset, and a multi-monitor set. When used as a computing device without mobile features, the monitor is a high resolution display. For games and other multi-display mode, the multi-monitor set provides high-resolution with multiple monitors (e.g., three monitors). When used for mobile communication, the screen provides the primary interface for the user to navigate, access various applications and perform tasks. The screen may use organic light-emitting diode (OLED) (super retina) display with multi-touch or haptic touch feature. The mass storage 136 may include CD-ROM, hard disk, and solid-state drives (SSDs). The I/O controller 130 also has a network interface card (NIC) 145 which provides an interface to a network and wireless medium 148.

Additional devices or bus interfaces may be available for interconnections and/or expansion. Some examples may include the Peripheral Component Interconnect Express (PCIe) bus, the Universal Serial Bus (USB), etc.

The RF transceiver circuit 150 includes a transmitter 152, an antenna array 158, a voltage-controlled oscillator (VCO) 156, and a receiver 154. The RF circuit 150 operates at a high GHz frequency band to accommodate modern cellular equipment such as the wireless fifth generation (5G).

The transmitter 152 transmits the digital baseband data to the antenna array 158. The transmitter 152 may include a digital-to-analog converter (DAC), an automatic gain controller (AGC), an intermediate frequency (IF) circuit, a mixer, an RF circuit, and a power amplifier (PA). Other components may include filters, amplifiers, multiplexers, coaxial cables, phase shifters, etc. The DAC converts digital data f₁ into an analog signal f₂. The AGC automatically adjusts the signal amplitude of f₂ to generate a signal f₃ to maintain a consistent strength level in a dynamic and changing environment. The IF circuit performs intermediate frequency processes such as filtering to generate a signal f₄. The mixer converts the frequency of the signal f₄ to another frequency. This is done by mixing the signal f₄ with a signal vₜ from the VCO 156. Mixing here refers to frequency modulation which translates the signal f₄ to a signal f₅ at a different frequency. For transmitter, the translated frequency is higher than the frequency of f₄. The conversion is called up-conversion. For 5G communication, the frequency range may include low-band (below 1 GHz), mid-band (1 GHz to 6 GHz), and high-band (24 GHz to 53 GHz or higher). The resulting signal f₅ then goes through various radio frequency processes performed by the RF circuit such as high-pass filtering to produce a signal f₆. The signal f₆ is strengthened and amplified by the PA to produce a signal f₇. The signal f₇ then goes to the antenna array 158 to be transmitted to an appropriate destination and medium (e.g., base station). The antenna array 158 uses beam forming to focus radio waves from f₇ in a desired direction. The antenna array 158 may be used for both transmitting and receiving. On receiving, the antenna array 158 receives an RF signal and sends it to the receiver 154. The number of antennas in the antenna array 158 depends on the desired coverage. The antenna array 158 may include antennas 161, 162, 163, and 164 configured to operate with 5G communication, Gigabit Long Term Evolution (LTE), Wi-Fi (e.g., 2.4 GHz, 5 GHz, and 6Ghz), and Bluetooth, respectively. The number of antennas may be more or less than the above.

The VCO 156 couples multiple in-phase oscillators together to provide low phase noise oscillation. It generates signals vₜ; and vᵣ to the mixers at specified frequencies. It may include multiple oscillation core circuits (or VCO cores) to provide high-frequency periodic signals.

The receiver 154 processes the received signal r₇ in a manner reverse from the transmitter 152. It may include a low noise amplifier (LNA), an RF circuit, a mixer, an IF circuit, an AGC, and an analog-to-digital converter (ADC). The receiver 154 may include more or less than the above components. The LNA amplifies the weak signal r₇ while maintaining a good signal-to-noise ratio (SNR) to produce a signal r₆ for further processing. The signal r₆ is next processed by the RF circuit such as band-pass filtering to provide a signal r₅. Additional filtering may be performed in the next stages. The signal r₅ is then mixed with the signal vᵣ from the VCO 156 to down convert the signal r₅ to a signal r₄ at an appropriate low frequency. Like the mixer in the transmitter 152 but with a reverse operation, the mixer in the receiver performs frequency modulation to translate the high frequency signal r₅ to a low frequency signal r₄. The signal r₄ goes through IF processing such as additional filtering by the IF circuit to produce a signal r₃. The AGC amplifies and strengthens the signal and generates a signal r₂. The ADC converts the analog signal r₂ into digital data r₁ which will be processed by the CPU 110.

The analog baseband circuit 170 provides analog processing for various components. It handles processing of signals and data between the digital baseband circuit and the RF transceiver circuit 150. It may include analog and digital components to perform various tasks including modulation/demodulation, controlling the RF transceiver circuit 150, special circuitry for 3G, 4G/LTE, Bluetooth, and 5G communication. It may also interface with an audio device circuit 174, a sensor circuit 176, a Subscriber Identity Module (SIM) card 178, and other components. The audio device circuit 174 may include operational blocks to process audio signals and perform audio-related functions such as filtering, correlation, speech recognition. It may include digital circuits to perform Fast Fourier Transform (FFT) to perform signal processing in the frequency domain. The sensor circuit 176 may include a variety of sensors such as proximity, ambient light, motion (accelerometer and gyroscope, compass, barometer, fingerprint sensor for touch identification (ID), image sensors for face ID, light detection and ranging (LiDAR) scanner, etc. The SIM card 178 is a small, removable chip that stores the user's phone number and carrier information, allowing the device to connect to a cellular network.

The power supply and battery circuit 180 provides power and battery backup supply to the entire system. It may include a charger to charge the battery. The battery may be a rechargeable battery, of Lithium-Ion battery. Power management may be performed by application software and circuits to provide low power mode and performance management.

The system 100 is an example that illustrates the role of 3-D memory devices in a laptop, desktop or mobile environment. In many cases, the environment of the applications adds additional requirements including low power consumption, reliable signal integrity, fault-tolerance, and reliable operations in extreme conditions including heat and tight space. Examples of other applications that would benefit from 3-D memory devices or circuits include mobile communication (e.g., smart phones, base stations, user equipment), cameras, vehicles, entertainment (e.g., games, multimedia, music, movies), technical designs (e.g., animation, graphics), medical (e.g., visualization, medical imaging), robotics, drones, automatic test equipment, audio processing, speech synthesizer, video and image analysis, vision, automatic face recognition, artificial intelligence (AI) applications, and data centers.

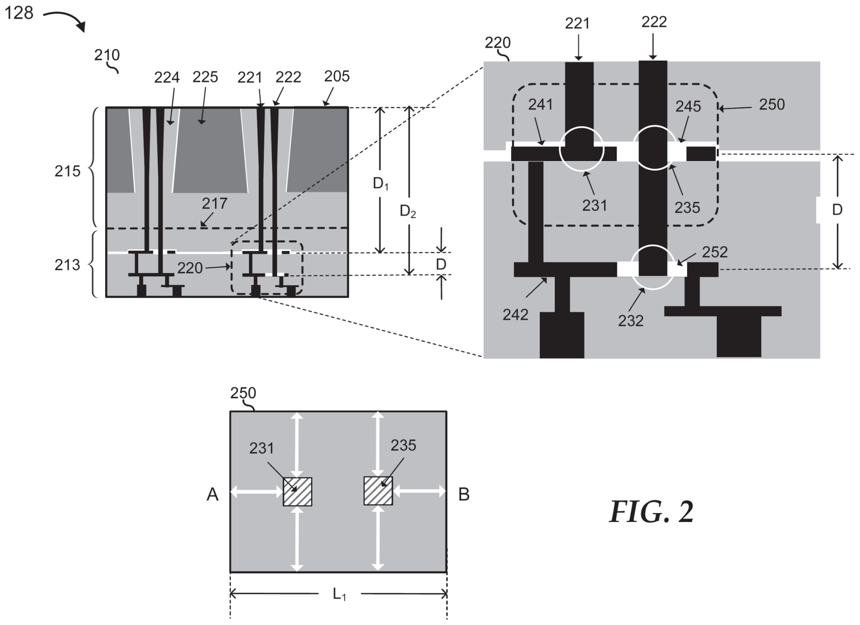

FIG. 2 is a diagram illustrating a contact structure in the 3-D memory circuit 128 shown in FIG. 1 according to an embodiment. The 3-D memory circuit 128 includes a contact structure 210. The contact structure 210 is a part of an overall contact structure in the 3-D memory circuit 128. It provides interconnections to wordlines or other signal lines such as bit lines, control lines, etc. The contact structure 210 includes two regions 213 and 215.

The two regions 213 and 215 represent two semiconductor parts such as wafers or dies. The two parts are joined, connected, or bonded together at a line 217 to become a single part. The process of manufacturing the contact structure 210 will be described later. The contact structure includes a substrate or dielectric region 224 and a silicon region 225. The substrate or dielectric region 224 includes components that form a contact structure for connections to various parts in the 3-D memory circuit 128. The silicon region 225 includes subregions or areas that are reserved for silicon circuits.

The contact structure 210 as shown includes two pairs of contact pillars. For illustrative purposes, it is sufficient to describe one pair. The pair includes a first contact pillar 221 and a second contact pillar 222. A contact pillar may be obtained from a through-substrate deep via (TSDV) or a through silicon via (TSV), or a contact hollow that may be filled with metal. It is a vertical electrical connection, or via, that penetrates through the entire thickness of a substrate or wafer. It enables direct connections between different layers or dies within a chip. The first and second contact pillars 221 and 222 start from a surface line 205 at the top of the region 215 and penetrate deep through the regions 215 and 213. The surface line 205 corresponds to a top surface of the region 215. The surface line 205 is arranged in a first direction. In one embodiment, the first direction is a horizontal direction. An expanded view 220 shows the arrangement or connections of the first and second contact pillars 221 and 222 with other components in the region 213. The expanded view 220 includes a section 250 which shows the connections with a first metal layer or line 241. The first contact pillar 221 lands or makes contact on a first metal layer 241 at a contact point 231. A pad may be formed at the first contact point 231 for interconnection. The second contact pillar 222 goes deeper than the first contact pillar 221, through the first metal layer 241 and lands or contacts a second metal layer or line 242 at a second contact point 232. A pad may be formed at the second contact point 232 for interconnection. First and second contact pads are at the first and second contact points 231 and 232, respectively. For clarity, the first and second contact points 231 and 232 may also refer to the respective contact pads and are points to connect to WL and other lines in the 3-D memory circuit 128. The first metal layer 241 is positioned at a depth distance of D₁ from the surface line 205. The second metal layer 242 is positioned at a depth distance of D₂ from the surface line 205. In one embodiment, D₂ > D₁. In other words, the first contact pillar is connected to the contact point 231 on the first metal layer 241 in the semiconductor region 213 at the depth D₁, and the second contact pillar is connected to the contact point 232 on the second metal layer 242 in the semiconductor region 213 at the depth D₂ deeper or longer than the depth D₁ with respect to a top surface of the semiconductor region 215 on top of the semiconductor region 213. The distance D, where D = D₂ - D₁, between the first metal layer 241 and the second metal layer 242 may be defined by the geometry of the two contact pillars 221 and 222 (e.g., width) and the desired isolation between the two pillars. The two contact pillars 221 and 222 are protected or isolated by isolation or dielectric layers 245 and 252, respectively. The contact pillar 222 lands on the second metal layer 242 by going through the first metal layer 241 at a punch-through point 235.

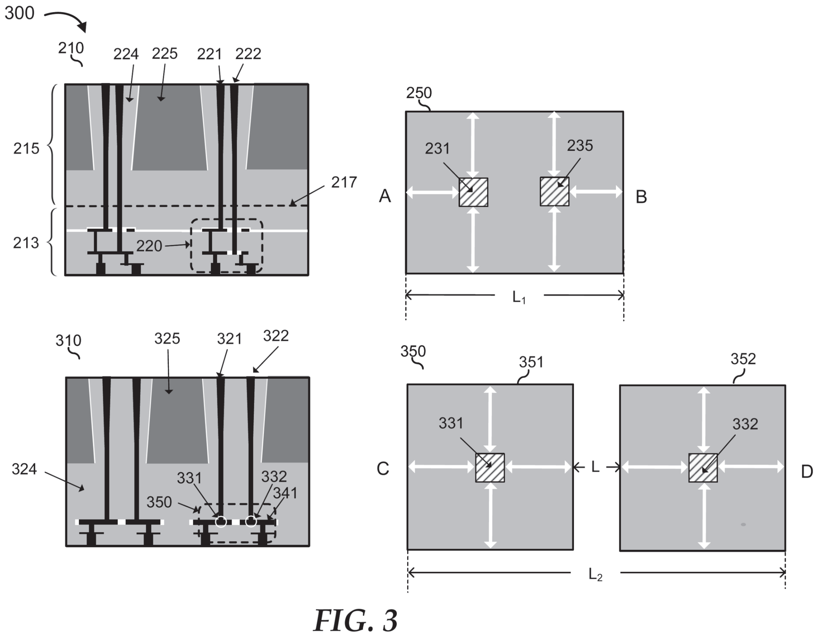

The section 250 illustrates the space occupied by the two contact pillars 221 and 222 and the metal layers 241 and 242. Viewed from the top, the section 250 shows the distance between the two pillars defined by the contact point 231 and the punch-through point 235, or the distance between a left isolation point A of the contact point 231 and a right isolation point B of the punch-through point 235. For illustrative purposes, this distance is shown as L₁. As will be shown in FIG. 3, this distance L₁ will be compared with a corresponding distance in a contact structure using lateral isolation.

FIG. 3 is a diagram illustrating a comparison between the contact structure 210 with vertical isolation shown in FIG. 2 and a contact structure 310 with lateral isolation according to an embodiment.

The contact structure 210 and the top view of the section 250 are shown in FIG. 2 and repeated here for comparison convenience. The contact structure 210 employs vertical isolation defined by the depth difference D between the two pillars 221 and 222. The isolation between the contact pads from the two pillars 221 and 222 at the respective metal layers 241 and 242 is vertical. In contrast, the contact structure 310 employs lateral or horizontal isolation.

As with the contact structure 210, the contact structure 310 includes a substrate or dielectric region 324 and a silicon region 325. There is one metal layer 341. The two first contact pillar 321 and the second contact pillar 322 land or make contact on the same metal layer 341 at the first contact point 331 and the second contact point 332, respectively. A section including the contact points 331 and 332 is shown in an expended view 350. The expanded view 350 shows the distance relationship between the contact points 331 and 332 as seen from the top.

The view 350 shows a first section 351 surrounding the first contact point 331 and a second section 352 surrounding the second contact point 332. The two sections 351 and 352 are separated by an isolation region having a length L. For comparison purposes, the two sections 351 and 352 define the space occupied by the contact structure 310 with the contact pillars 321 and 322. This space is measured as the distance L₂ from one end of the section 351, isolation point C on the left of the first contact point 331, to another end of the section 352, isolation point D on the right of the second contact point 332. Since separation between the first contact point 231 and the punch-through point 235 in the contact structure 210 is much shorter than that in the contact structure 310, the resulting length L₁ is much shorter than L₂. Because of this, the contact structure 210 provides a large space saving so that more space can be allocated for the silicon region 225 after taking into account bonding margin.

It should be noted that the space saving due to the vertical isolation of the contact structure 210 is shown for a single pair of contact pillars corresponding to two WLs. In practice, the number of WLs in a typical 3-D memory circuit 128 may be large, ranging from dozens to hundreds. Accordingly, the overall space saving thanks to the vertical isolation scheme is significant.

There are several stages in the process of manufacturing the contact structure. Each stage may include a few steps. In the following the stages or processes are described to present the basic functions. The figures are shown mainly for illustrative purposes. They may not accurately depict the components in exact shape or form. Figures are drawn with shading or patterns for clarity. A component may have different shades or patterns from one figure to the next because of considerations for clarity.

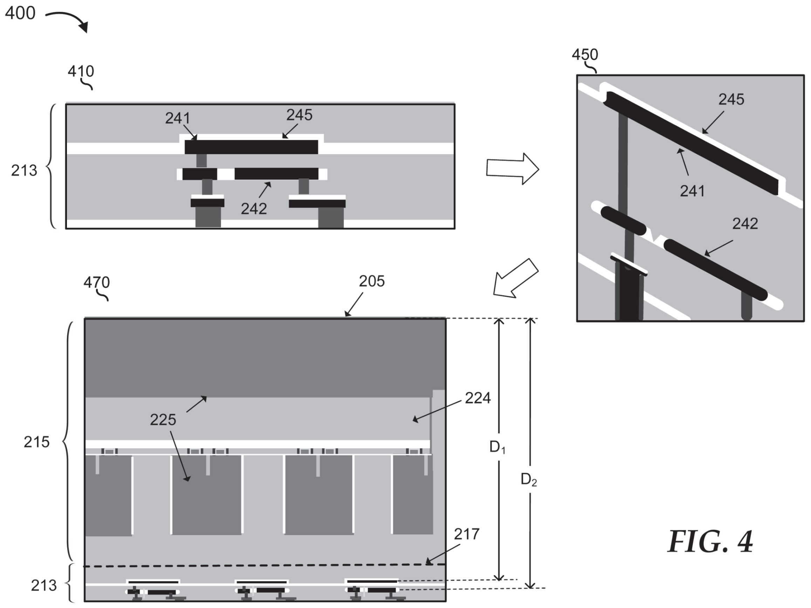

FIG. 4 is a diagram illustrating a first stage 400 of the manufacturing process of the contact structure according to an embodiment. The first stage 400 includes steps 410 and 470. Some components in FIG. 4 share the same reference numerals as those in FIG. 2. For simplicity, these reference numerals are retained in FIG. 4 because they refer to the same components.

The first stage 400 is to bond two semiconductor regions 213 and 215 (in FIG. 2) together. A semiconductor region or part may be a wafer, a die, a substrate, a device, a component, a slice of semiconductor material (e.g., silicon), or any object that can be etched, imprinted, filled in, or modified to incorporate a circuit, a design, or a layout.

Step 410 forms two metal layers in the first semiconductor region 213: a first metal layer 241 and a second metal layer 242, as shown in FIG. 2. Step 410 also deposits a dielectric (e.g., silicon nitride) layer 245 as a stop layer on the first metal layer 241. The arrangement of the two layers 241 and 242 may be shown in 3-D in a view 450. The view 450 shows the 3-D configuration of the two metal layers 241 and 242 with the dielectric layer 245.

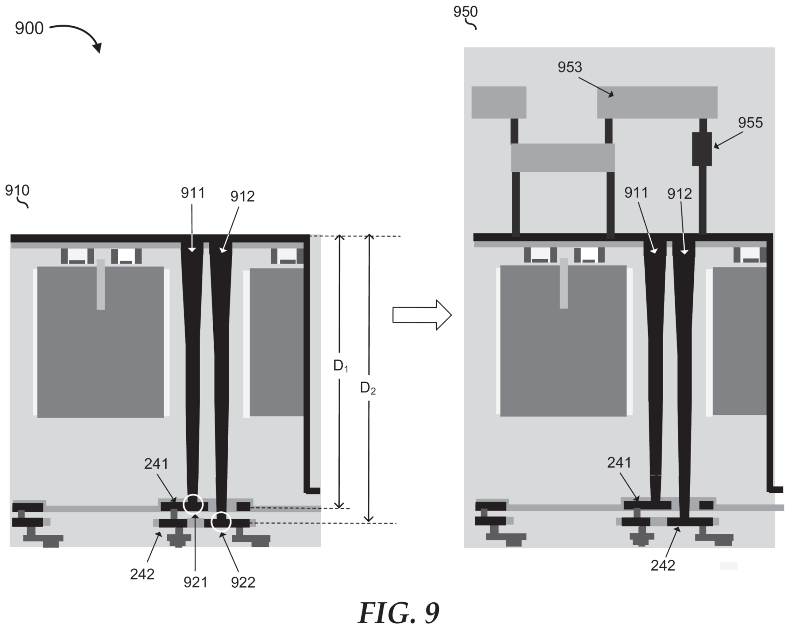

Step 470 bonds the two semiconductor regions 213 and 215 together at the joining line 217. Any suitable bonding techniques may be employed including direct bonding, adhesive bonding, anodic bonding, eutectic bonding, thermocompression bonding, and hybrid bonding. The semiconductor region 215 is placed on top of the semiconductor region 213. It has the substrate or dielectric region 224 and the silicon region 225 (FIG. 2). The surface line 205 (in FIG. 2) defines the top reference horizontal line from which the depths of the first and second metal layers 241 and 242 are measured as D₁ and D₂, respectively, as shown in FIG. 2. The depths D₁ and D₂ are also shown in FIG. 9.

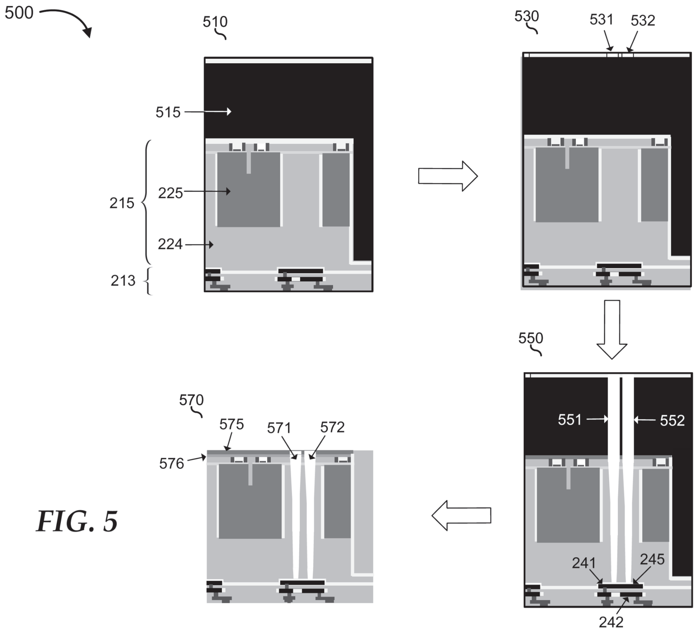

FIG. 5 is a diagram illustrating a second stage 500 of the manufacturing process of the contact structure according to an embodiment. The second stage 500 includes steps 510, 530, 550, and 570. The second stage 600 may include more or less than the above steps.

Step 510 forms a hard mask layer 515 deposited on top of the semiconductor region 215. In one embodiment, the hard mask layer 515 uses an amorphous carbon layer (ACL) material. A dielectric layer may be formed on the hard mask 515. Step 530 opens a first opening 531 and a second opening 532 to prepare for etching TSDVs. To do this, step 530 creates a pattern using a precision technique. Any suitable precision technique may be used. For example, in one embodiment, step 530 uses Argon fluoride (ArF) lithography with a laser having a 193 nm wavelength to form the openings 531 and 532. Step 550 etches holes to form a first TSDV 551 and a second TSDV 552 which correspond to two contact pillars in the end. Both the TSDVs 551 and 552 land on, or contact, the layer 245 on the first metal layer 241. Step 570 ashes or removes the ACL material of the hard mask 515, leaving a hard mask layer 575 and a dielectric layer 576 on the surface of the second semiconductor region 215. The TSDVs 551 and 552 become a first TSDV 571 and a second TSDV 572, respectively.

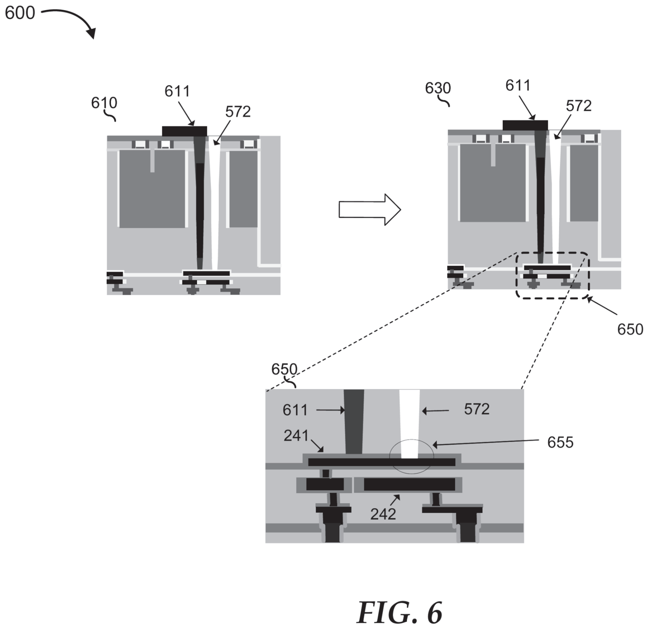

FIG. 6 is a diagram illustrating a third stage 600 of the manufacturing process of the contact structure according to an embodiment. The third stage 600 includes steps 610 and 630. The third stage 600 may include more or less than the above steps.

Step 610 blocks the first TSDV 571 using a precision pattern created by a precision lithography tool to form a blocked TSDV 611. Any suitable precision technique may be used. For example, in one embodiment, step 610 uses Krypton fluoride (KrF) excimer laser with 248 nm wavelength. Step 630 removes the dielectric (e.g., silicon nitride) at the bottom of the second TSDV 572 as shown in an expanded view 650. The expanded view 650 shows an area 655 where the silicon nitride is removed.

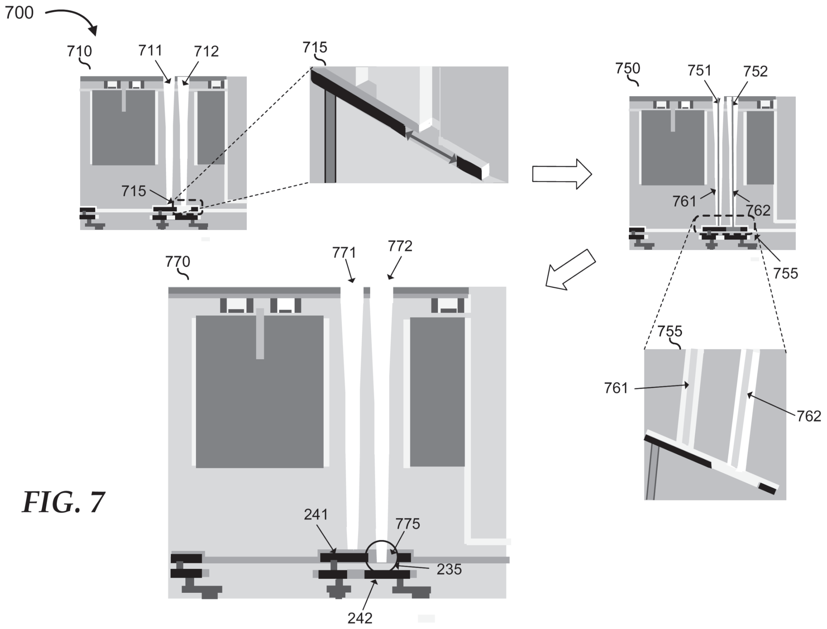

FIG. 7 is a diagram illustrating a fourth stage 700 of the manufacturing process of the contact structure according to an embodiment. The fourth stage 700 includes steps 710, 750, and 770. The fourth stage 700 may include more or less than the above steps.

Step 710 performs a photoresist (PR) ash for the blocked TSDV 611 to form a first TSDV 711. In addition, step 710 performs a lateral recess of conducting material, such as tungsten (W), in the second TSDV 572 to form a second TSDV 712. The lateral recess etching is shown in an expanded view 715. Step 750 forms a liner 761 in the first TSDV 711 and a liner 762 in the second TSDV 712 to form a first lined TSDV 751 and a second lined TSDV 752, respectively. Each of the liners 761 and 762 has an appropriate thickness in relative to the width of the corresponding TSDV. In one embodiment, the liner is silicon nitride. For illustrative purposes, an expanded view 755 shows the liner with a thickness of 20 nm and the TSDVs 751 and 752 having widths from 100 nm to 125 nm.

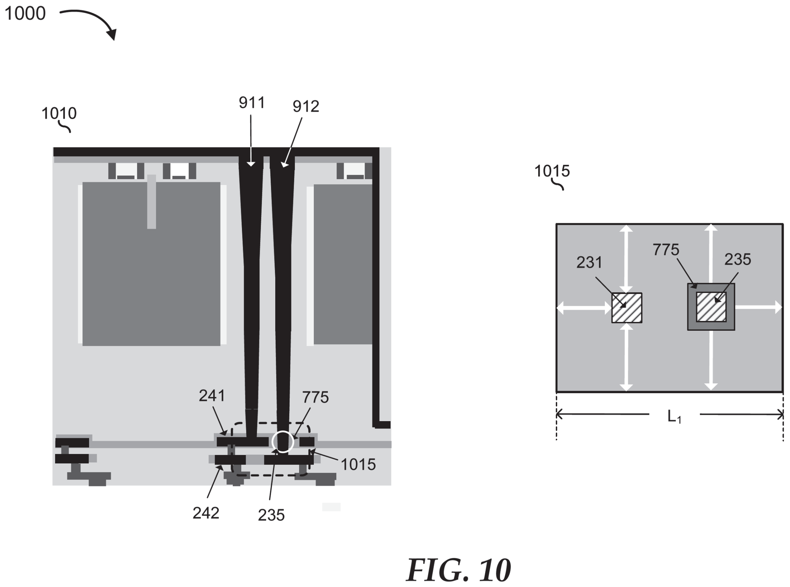

Step 750 performs an etch back at the bottoms of the first lined TSDV 751 and the second lined TSDV 752 to form a first TSDV 771 and a second TSDV 772. In one embodiment, a capping layer of silicon nitride may be deposited to protect the tungsten (W) material of the first metal layer 241 from oxidation during photoresist (PR) removal at a punch-through location 235. The punch-through location 235 is a location at which the second TSDV 772 will punch through to land on, or contacts, the second metal layer 242 in a subsequent stage. In addition, an isolation layer 775 is formed around the punch-through location 235 to isolate the second TSDV 772 from the first metal layer 241. In one embodiment, the isolation layer 775 is a dielectric. The isolation layer 775 will be further described in FIG. 10.

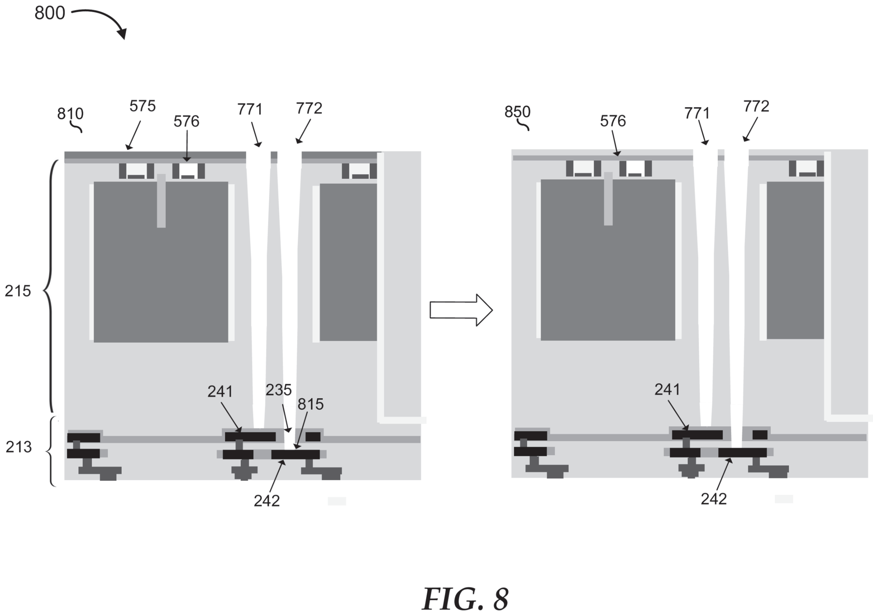

FIG. 8 is a diagram illustrating a fifth stage 800 of the manufacturing process of the contact structure according to an embodiment. The fifth stage 800 includes steps 810 and 850. The fifth stage 800 may include more or less than the above steps.

Step 810 etches holes to form the second TSDV 772 to form a second landing or contact point 815 at the punch-through location 235 and lands on, or contacts, the second metal layer 242 at the contact point 815. The layers 575 and 576 (FIG. 5) remain on the surface of the second semiconductor region 215. Step 850 removes the hard mask layer 575.

FIG. 9 is a diagram illustrating a sixth stage 900 of the manufacturing process of the contact structure according to an embodiment. The sixth stage 900 includes steps 910 and 950. The sixth stage 900 may include more or less than the above steps.

Step 910 fills metal into the first TSDV 771 and the second TSDV 772 to form a first contact pillar 911 and a second contact pillar 912, respectively. In one embodiment, the metal is any suitable conducting material such as one of titanium nitride (TiN) or tungsten (W). The first contact pillar 911 contacts or connects to the first metal layer 241 at a contact point 921. The second contact pillar 912 contacts or connects to the second metal layer 242 at a contact point 922. The first and second contact points 921 and 922 are isolated in a second direction along, or with respect to, the first and second depths D₁ and D₂, as illustrated in FIG. 2 and FIG. 4. The second direction is substantially perpendicular to the first direction of the surface line 205 in FIG. 2. Step 950 patterns metal contacts and metal lines 953 and 955 for logic circuits and other connections. The contact pads at the contact points 921 and 922 have a vertical isolation sufficient for protection and/or isolation.

Variations of the above stages and steps may be carried out. For example, in some embodiments, during the etching of the second TSDV, the top part of the second TSDV may be etched laterally. In some embodiments, the etching of the TSDVs may start with narrow initial critical dimensions (CDs) and subsequently optimized based on the etch rate.

FIG. 10 is a diagram illustrating a lateral isolation at the punch-through location 235 shown in FIG. 2 of the contact structure according to an embodiment. The stages shown in FIGS. 7 and 8 illustrate the second TSDV 912 punching through the first metal layer 241 at the punch-through location 235.

At the punch-through location 235, the TSDV 912 is isolated from the first metal layer 241 by an isolation layer 775. The isolation layer 775 surrounds the second TSDV 912 at the punch-through location 235. The section is expanded in a top view 1015. The top view 1015 shows the isolation layer 775 surrounding the punch-through location 235. As discussed earlier, the horizontal distance between the first TSDV 911 and the second TSDV 912 on the first metal layer 241 is shortened as L₁, leaving more space in the second semiconductor region 215 for silicon.

The concept of converting a lateral or horizontal isolation to vertical isolation to shorten the horizontal distance between two contact pillars is not limited to two contact pillars. It may be extended to multiple contact pillars.

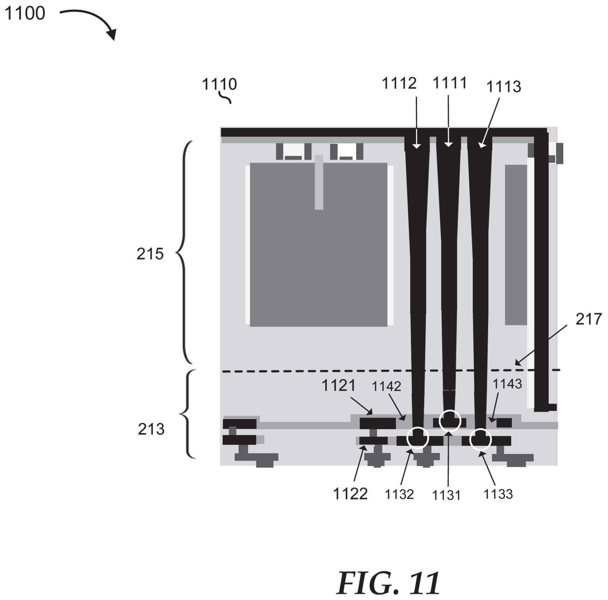

FIG. 11 is a diagram illustrating a three-pillar structure 1100 of the contact structure according to an embodiment. The three-pillar structure 1100 is similar to the two-pillar structure except that it has three contact pillars instead of two contact pillars. It includes a first semiconductor region 213, the second semiconductor region 215, a first contact pillar 1111, a second contact pillar 1112, a third contact pillar 1113, a first metal layer 1121, and a second metal layer 1122. The contact structure 1100 may include more or less than the above components.

The first contact pillar 1111 lands on, contacts, or is connected to, the first metal layer 1121 at a first contact point 1131. The second contact pillar 1112 lands on, contacts, or is connected to, the second metal layer 1122 at a second contact point 1132. The third contact pillar 1113 lands on, contacts, or is connected to, the second metal layer 1122 at a third contact point 1133. The second and third contract pillars 1112 and 1113 punch through the first metal layer 1121 at punch-through locations 1142 and 1143. In one embodiment, the first semiconductor region 213 may have three metal layers: the first metal layer 1121, the second metal layer 1122, and a third metal layer 1123 (not shown). In this configuration, the third contact pillar 1113 lands on, contacts, or is connected to the third metal layer 1123, at a third contact point 1133' (not shown).

The space saving of the three-pillar structure may be more than the two-pillar structure. The trade-off is the additional contact pillar and a more complex metal layer circuit in the first semiconductor region 213 and a more involved fabrication process.

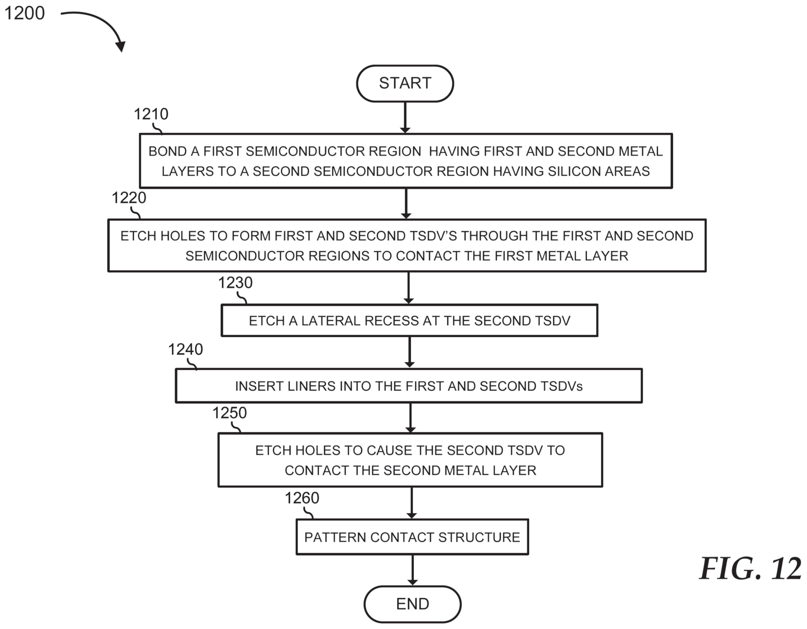

FIG. 12 is a flowchart illustrating a process 1200 of manufacturing a contact structure according to an embodiment. The process 1200 corresponds to the first through six stages described in FIGS. 4 through 9.

Upon START, the process 1200 bonds a first semiconductor part having first and second metal layers to a second semiconductor part having silicon areas (Block 1210). The first and second semiconductor parts may be wafers or dies. Block 1210 corresponds to the first stage 400 shown in FIG. 4. Next, the process 1200 etches holes to form first and second TSDVs through the first and second semiconductor regions to land on or contact the first metal layer (Block 1220). Block 1220 corresponds to the second stage 500 shown in FIG. 5.

Then, the process 1200 includes etching a lateral recess at the second TSDV (Block 1230). Block 1230 corresponds to the third stage 600 shown in FIG. 6. Next, the process 1200 includes inserting liners into the first and second TSDVs (Block 1240). Block 1240 corresponds to the fourth stage 700 shown in FIG. 7. Then, the process 1200 includes etching holes to form the second TSDV to land on, or contact, the second metal layer (Block 1250). Block 1250 corresponds to the fifth stage 800 shown in FIG. 8. Next, the process 1200 includes patterning contact structure (Block 1260). Block 1260 corresponds to the sixth stage 900 shown in FIG. 9. The process 1200 is then terminated

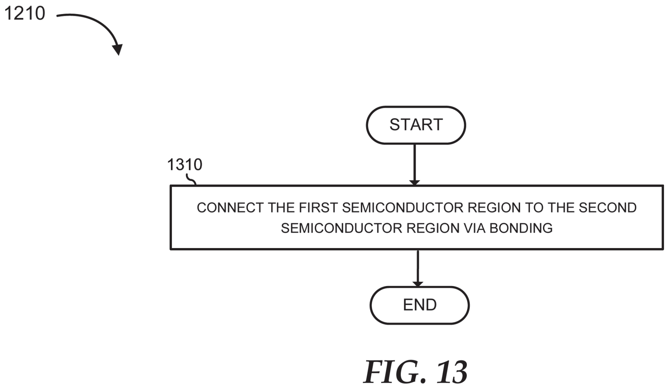

FIG. 13 is a flow chart illustrating the block 1210 shown in FIG. 2 of bonding two semiconductor regions in the manufacturing process of the contact structure according to an embodiment.

Upon START, the block 1210 includes connecting the first semiconductor region to the second semiconductor region via bonding (e.g., fusion boding) (Block 1310). Block 1310 corresponds to the step 470 shown in FIG. 4. In some embodiments, the first semiconductor region has memory cell circuits and the second semiconductor region has logic circuits. The block 1210 is then terminated.

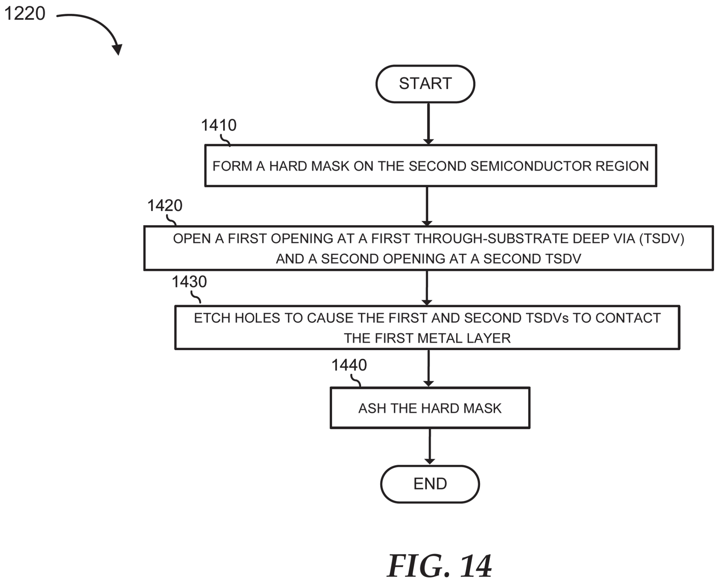

FIG. 14 is a flow chart illustrating the block 1220 shown in FIG. 2 of etching holes to form first and second contact pillars in the manufacturing process of the contact structure according to an embodiment.

Upon START, the block 1220 includes forming a hard mask on the second semiconductor part (Block 1410). Block 1410 corresponds to step 510 in FIG. 5. Next, the block 1220 includes opening a first opening at a first through-substrate deep via (TSDV) and a second opening at a second TSDV (Block 1420). Block 1420 corresponds to step 530 in FIG. 5. Then, the block 1220 includes etching holes to form the first and second TSDVs to land on, or contact, the first metal layer (Block 1430). Block 1420 corresponds to step 550 in FIG. 5. Next, the block 1220 includes ashing the hard mask (Block 1440). Block 1440 corresponds to step 570 in FIG. 5. The block 1220 is then terminated.

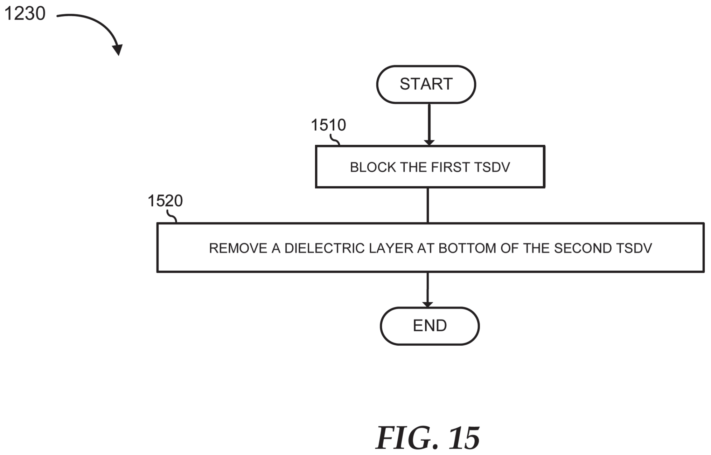

FIG. 15 is a flow chart illustrating the block 1230 shown in FIG. 2 of cleaning the second TSDV in the manufacturing process of the contact structure according to an embodiment.

Upon START, the block 1230 includes blocking the first TSDV (Block 1510). Block 1510 corresponds to step 610 in FIG. 6. Next, the block 1230 includes removing a dielectric (e.g., silicon nitride) layer at bottom of the second TSDV (Block 1520). Block 1520 corresponds to the expanded view 650 in FIG. 6. The block 1230 is then terminated.

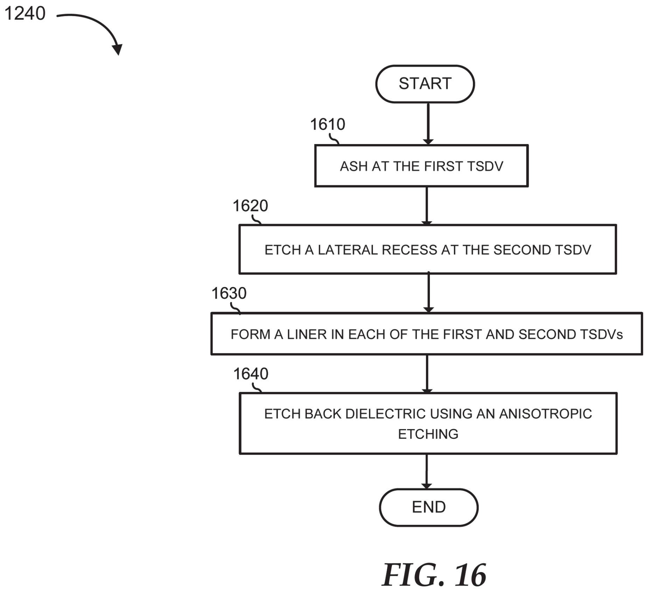

FIG. 16 is a flow chart illustrating the block 1240 shown in FIG. 12 of inserting liners into the TSDVs in the manufacturing process of the contact structure for a memory circuit according to an embodiment.

Upon START, the block 1240 includes ashing at the first TSDV (Block 1610). Next, the block 1240 includes etching a lateral recess at the second TSDV (Block 1620). Blocks 1610 and 1620 correspond to step 710 in FIG. 7. Next, the block 1240 includes forming a liner in each of the first and second TSDVs (Block 1630). Block 1630 corresponds to step 750 in FIG. 7. Then, the block 1240 includes etching back dielectric using an anisotropic etching (Block 1640). Block 1640 corresponds to step 770 in FIG. 7. The block 1240 is then terminated.

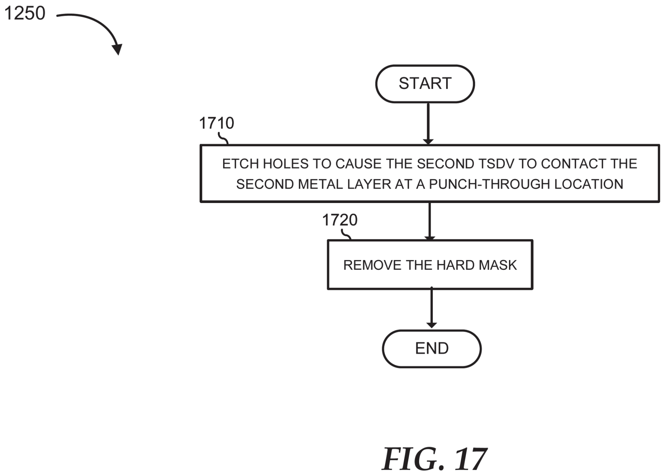

FIG. 17 is a flow chart illustrating the block 1250 shown in FIG. 12 of etching holes to cause the second TSDV to land on, or contact, the second metal layer in the manufacturing process of the contact structure according to an embodiment.

Upon START, the block 1250 includes etching holes to cause the second TSDV to land on, or contact, the second metal layer at a punch-through location (Block 1710). Block 1710 corresponds to step 810 in FIG. 8. Next, the block 1250 includes removing the hard mask (Block 1720). Block 1720 corresponds to step 850 in FIG. 8. The block 1250 is then terminated.

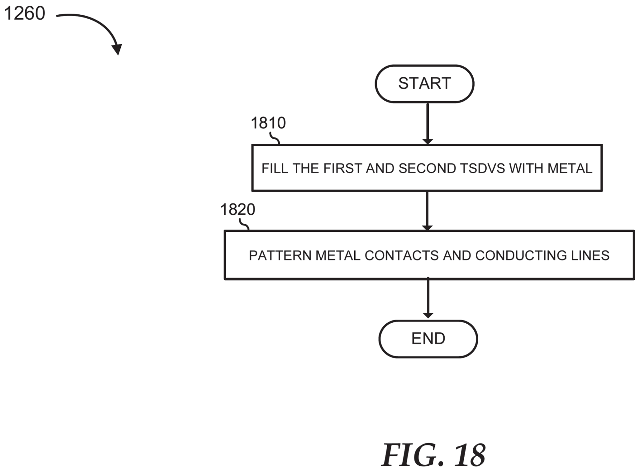

FIG. 18 is a flow chart illustrating the block 1260 shown in FIG. 12 of patterning in the manufacturing process of the contact structure according to an embodiment.

Upon START, the block 1260 includes filling the first and second TSDVs with metal to form first and second contact pillars, respectively (Block 1810). Block 1810 corresponds to step 910 in FIG. 9. Next, the block 1260 includes patterning metal contacts and conducting lines for logic circuits and other circuits (Block 1820). Block 1820 corresponds to step 950 in FIG. 9. The block 1260 is then terminated.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable sub-combination. Moreover, although features may be described above as acting in certain combinations and even initially claimed as such, one or more features from a claimed combination may in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a first contact pillar connected to a first contact point on a first metal layer in a first semiconductor region at a first depth; and
a second contact pillar connected to a second contact point on a second metal layer in the first semiconductor region at a second depth deeper than the first depth with respect to a top surface of a second semiconductor region on top of the first semiconductor region,
wherein the first and second contact points are isolated in a direction along the first and second depths, and
wherein the first and second metal layers correspond to first and second wordlines, WLs, respectively, of a memory circuit.

2. The device of claim 1, wherein the first and second contact pillars are through-substrate or silicon deep vias, TSDV.

3. The device of claim 2, wherein the first and second TSDVs are filled with a conducting material comprising at least one of titanium nitride, TiN, or tungsten. W.

4. The device of any one of claims 1 to 3, wherein the first and second contact pillars form a multi-level bonding structure around the first and second contact points and the first and second metal layers.

5. The device of any one of claims 1 to 4, wherein the second contact pillar punches through the first metal layer at a first punch-through location.

6. The device of claim 5, wherein a dielectric layer isolates the second contact pillar at the first punch-through location.

7. The device of any one of claims 1 to 6, further comprising:
first and second contact pads at the first and second contact points,
wherein the first and second contact pads are separated by isolation with respect to the direction.

8. The device of any one of claims 1 to 7, further comprising:
a third contact pillar connected to a third contact point on a third metal layer at a third depth.

9. The device of claim 8, wherein the third depth is equal to the second depth and the third metal layer is on a same plane with the second metal layer.

10. The device of claim 8 or 9, wherein the third contact pillar punches through the first metal layer at a second punch-through location.

11. A method comprising:
bonding a first semiconductor region having first and second metal layers to a second semiconductor region having silicon areas;
etching holes to form first and second through-substrate deep vias, TSDVs, through the first and second semiconductor regions to contact the first metal layer;
cleaning the second TSDV;
isolating the first TSDV from the first metal layer;
etching holes to cause the second TSDV to contact the second metal layer; and
patterning contact structure.

12. The method of claim 11, wherein bonding comprises:
connecting the first semiconductor region to the second semiconductor region via bonding,
wherein the first semiconductor region has memory cell circuits and the second semiconductor region has logic circuits.

13. The method of claim 11 or 12, wherein etching holes to form first and second TSDVs comprises:
forming a hard mask on the second semiconductor region;
opening a first opening at the first TSDV and a second opening at the second TSDV;
etching holes to cause the first and second TSDVs to contact the first metal layer; and
ashing the hard mask.

14. The method of any one of claims 11 to 13, wherein cleaning the second TSDV comprises:
blocking the first TSDV; and
removing a dielectric layer at bottom of the second TSDV.

15. The method of any one of claims 11 to 14, wherein inserting liners into the first and second TSDVs comprises:
ashing at the first TSDV;
etching a lateral recess at the second TSDV;
forming a liner in each of the first and second TSDVs; and
etching back dielectric using an anisotropic etching.
